# EUROPEAN PATENT SPECIFICATION

(11) **EP 1 965 410 B1**
(45) Date of publication and mention of the grant of the patent: **07.04.2010**
(21) Application number: 08001912.8
(22) Date of filing: 01.02.2008
(51) Int. Cl.: H01L 21/00

(54) **Single wafer etching apparatus**
Einzelwaferätzgerät
Appareil de gravure d'une seule plaquette

(30) Priority: 01.03.2007 JP 2007051090
(43) Date of publication of application: 03.09.2008
(73) Proprietor: SUMCO CORPORATION, Minato-ku, Tokyo (JP)
(72) Inventor: Katoh, Takeo, Tokyo (JP); Hashii, Tomohiro, Tokyo (JP); Murayama, Katsuhiko, Tokyo (JP); Koyata, Sakae, Tokyo (JP); Takaishi, Kazushige, Tokyo (JP)
(74) Representative: Bertsch, Florian Oliver

(56) References cited:
- US-A1- 2002 026 985
- US-A1- 2003 129 850
- US-B1- 6 537 416

## Description

### BACKGROUND OF THE INVENTION

### 1. Field of the Invention

The present invention acording to claims 1 and 3 relates to an apparatus and a method for etching wafers one by one while rotating the wafer retained in a horizontal direction.

### 2. Description of the Rerated Art

Generally, a semiconductor wafer is manufactured by cutting a wafer out of a single-crystal ingot to slice the wafer to subject the wafer to chamfering, mechanical polishing (wrapping), etching, mirror polishing (polishing), and washing processes, thereby providing a wafer having an accurate flatness. A wafer obtained through machining processes such as a block cutting, outer diameter grinding, slicing, or a wrapping process has a damage layer (i.e., work-affected layer) at the upper face thereof. The work-affected layer induces a crystal fault such as slip dislocation in a device manufacture process to deteriorate the mechanical strength of the wafer and to have an adverse effect on the electrical characteristic. Thus, the work-affected layer must be removed perfectly. This work-affected layer is removed by subjecting the wafer to an etching processing. An etching processing includes an immersion etching or a single wafer etching.

The above single wafer etching can control the surface roughness and the texture size of a wafer having a large diameter and thus has been considered as an optimal etching method. The single wafer etching is a method to drip etching liquid on the upper face of a flattened wafer to rotate (or spin) the wafer in a horizontal direction to expand the dripped etching liquid over the entire upper face of the wafer to etch the wafer. The etching liquid supplied on the upper face of the wafer is caused to expand, by being expanded from the supply point to the entire upper face of the wafer, over the entire upper face of the wafer by the centrifugal force caused by the horizontal rotation of the wafer to reach the edge face of the wafer. Thus, the upper face of the wafer and the edge face of the wafer are etched simultaneously. The most part of the supplied etching liquid is blown off from the edge face of the wafer by the centrifugal force and is collected by a cup provided in the etching apparatus for example. However, a part of the etching liquid flows from the edge face of the wafer onto the lower face of the wafer. This has been a disadvantage in that the edge face and the lower face of the wafer are etched despite the intention.

In order to solve this disadvantage, a semiconductor substrate processing apparatus (see Patent Document 1 for example) has been disclosed. This semiconductor substrate processing apparatus is structured so that a table section of a semiconductor substrate fixing means retains the center of a discoid semiconductor substrate by vacuum suction, a rotation driving elevation means rotates and elevates the semiconductor substrate retained by the semiconductor substrate fixing means, and etching liquid is supplied through a nozzle of an etching liquid supply means to the surface of the semiconductor substrate retained by the semiconductor substrate fixing means. In this semiconductor substrate processing apparatus, the table section includes a ring blower nozzle having a ring-like slit and a guide section that is provided so as to be completely independent of the semiconductor substrate fixing means. The ring-like slit is provided at the outer side of the table section and at the lower side of the back face of the semiconductor substrate provided on the table section. The ring-like slit is also structured so that gas is uniformly blown threrethrough in an obliquely upward direction to the outer side in the radial direction of the outer periphery of the back face of the semiconductor substrate provided on the table section. The guide section is structured to guide the above blown gas along the back face of the semiconductor substrate provided on the table section to reach an end of the outer side of the center in the thickness direction of the semiconductor substrate.

In the case of the semiconductor substrate processing apparatus having the structure as described above, the gas uniformly blown through the ring-like slit to the outer periphery of the back face of the semiconductor substrate is guided by the guide section to the end of the outer side of the center in the thickness direction of the semiconductor substrate. Thus, the end of the outer side prevents the etching liquid from flowing to the lower face and thus can stop the etching at the center in the thickness direction of the semiconductor substrate. In this manner, edge faces can be uniformly etched when both faces of the semiconductor substrate are etched.
Patent Document 1:
Japanese Unexamined Patent Application Publication No. 2006-237502 (claim 1, paragraph [0009])

US 2002/026985 A1 discloses an etching device for etching a work piece comprising etching supply means with a center portion supply nozzle and two peripheral portion supply nozzles.

US 6,537,416 discloses a wafer chuck in which copper is removed from silicon wafers by providing H2SO4 to the central part of the wafer.

US 2003/0129850 discloses a system for planarizing metal conductive layers, a substrate support being rotated and the top surface being contacted with a liquid etching composition.

### SUMMARY OF THE INVENTION

However, in the case of the above conventional semiconductor substrate-processing apparatus disclosed by Patent Document 1, etching liquid is not sufficiently supplied to the outermost periphery of the semiconductor substrate, causing a disadvantage in that the shape of the outermost periphery of the edge face cannot be stable. Specifically, even with the guide for liquid blown from the back side used by the above conventional semiconductor substrate processing apparatus disclosed by Patent Document 1, etching liquid cannot be prevented from flowing to the edge face or back face of the wafer because such a flow is a complicated phenomenon caused by the centrifugal force, gravitational force, disordered etching liquid at the surface or the like. Since the first nozzle for supplying etching liquid to the upper face of a wafer moves on the upper face of the wafer, etching liquid supplied through the first nozzle on the surface of the wafer is disordered at the surface to cause a disordered flow rate of the etching liquid for etching the edge face of the wafer. This has caused a disadvantage in that the shape of the outermost periphery of the edge face cannot be stable to cause a difficulty in the control of the quality of the shape of the edge face.

It is an objective of the present invention to provide a single wafer etching apparatus that can stabilize the shape of the edge face of a wafer.

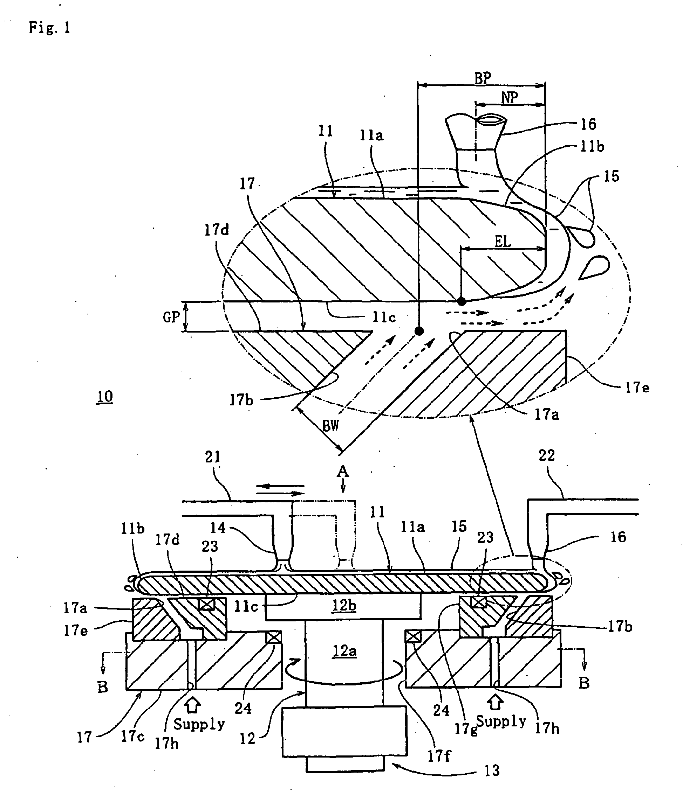

A first aspect of the present invention is, as shown in FIG. 1, an improvement of a single wafer etching apparatus 10 that supplies etching liquid 15 to an upper face 11a of a thin discoid wafer 11 obtained by slicing a semiconductor ingot while rotating the wafer 11 to etch the upper face 11a of the wafer 11 and an edge face 11b. The single wafer etching apparatus 10 is characterized in that the single wafer etching apparatus 10 includes a first nozzle 14 for supplying etching liquid 15 to the upper face 11a of the wafer 11 and a second nozzle 16 for supplying the etching liquid 15 to the edge face 11b of the wafer 11 that is opposed to the edge face 11b of the wafer 11.

In the single wafer etching apparatus according to the first aspect of the present invention, the wafer 11 is firstly rotated. While the wafer 11 being rotated, the etching liquid 15 is supplied to the upper face 11a of the wafer 11 to cause a centrifugal force caused by the in-plane rotation of the wafer 11 to gradually move the etching liquid 15 from the supply point toward the edge face 11b of the wafer 11 while etching the upper face 11a of the wafer 11, thereby etching the edge face 11b of the wafer 11. Then, the etching liquid 15 on the wafer 11 is scattered by the centrifugal force by the rotation of the wafer 11.

On the other hand, the etching liquid 15 of a sufficient amount is supplied from the second nozzle 16 opposed to the edge face 11b of the wafer 11 to the edge face 11b of the wafer 11. Thus, even when the etching liquid 15 supplied to the upper face 11a of the wafer 11 via the first nozzle 14 is disordered on the upper face 11a, the etching liquid 15 of a predetermined amount is always supplied in a uniform manner to the edge face 11b of the wafer 11. Thus, the etching liquid 15 flowing along the edge face 11b of the wafer 11 is prevented from being disordered. Thus, even when the first nozzle 14 for supplying the etching liquid 15 to the upper face 11a of the wafer 11 is moved on the upper face 11a of the wafer 11, the etching liquid 15 flowing along the edge face 11b of the wafer 11 can be uniform to provide the outermost periphery of the edge face 11b to have a stable shape.

Preferably the second nozzle 16 is fixed at a predetermined position in a range of -10 mm to 20 mm from the end of the outer periphery of the wafer 11 to the inner side of the wafer 11 in the radial direction. The single wafer etching apparatus according to the second aspect can allow the etching liquid 15 to uniformly flow along the edge face 11b of the wafer 11.

According to the invention, the single wafer etching apparatus includes a lower face blowing mechanism by which etching liquid flowing along the edge face of the wafer is blown off by gas jet toward the outer side in a radial direction of the wafer 11.

The single wafer etching apparatus of a wafer according to the third aspect can prevent etching liquid from flowing along the back face of the wafer 11. Thus, the outermost periphery of the edge face 11b of the wafer 11 can have a stable shape to control the quality of the shape of the edge face 11b with a relative ease.

According to the present invention, the first nozzle supplies etching liquid to the upper face of a wafer and the second nozzle opposed to the edge face of the wafer supplies etching liquid to the edge face of the wafer. Thus, a predetermined amount of etching liquid can be always supplied in a uniform manner from the second nozzle to the edge face of the wafer and thus the shape of the edge face of the wafer can be stable.

### BRIEF DESCRIPTION OF THE DRAWINGS

FIG. 1 is a longitudinal sectional view of the main part of a single wafer etching apparatus in an embodiment of the present invention;
FIG. 2 is a view of the etching apparatus of FIG. 1 seen from the point A before a wafer is provided on the apparatus;
FIG. 3 is a sectional view taken along the line B-B of FIG. 1;
FIG. 4 is a view of the variation of edge faces of wafers having lengths EL in the horizontal direction of an Example 1 and a Comparative Example 1;
FIG. 5 is a view of four directions for the photographing of the in-plane variation of the shape of the edge face of a wafer in the Example 1 and the Comparative Example 1; and
FIG. 6 is a photograph of the in-plane variation of the shape of the edge face of a wafer in the Example 1 and the Comparative Example 1.

### DETAILED DESCRIPTION OF THE PREFERRED EMBODIMENTS

Next, the best mode for carrying out the present invention will be described with reference to the drawings. As shown in FIG. 1, a single wafer etching apparatus 10 includes: a wafer chuck 12 that is stored in a chamber and that carries a single thin discoid silicon wafer 11 to retain the wafer 11 in a horizontal direction; a rotation means 13 that rotates the wafer 11 around the vertical center line in the horizontal in-plane; the first nozzle 14 that supplies etching liquid 15 onto an upper face 11a of the wafer 11 retained by the chuck 12; and the second nozzle 16 that supplies the etching liquid 15 to an edge face 11b of the wafer 11 retained by the chuck 12. The wafer 11 is obtained by slicing a single-crystal silicon ingot. The outer periphery edge of the wafer 11 (i.e., the edge face 11b of the wafer 11) is subjected to a convex chamfering processing to have a predetermined curvature radius.

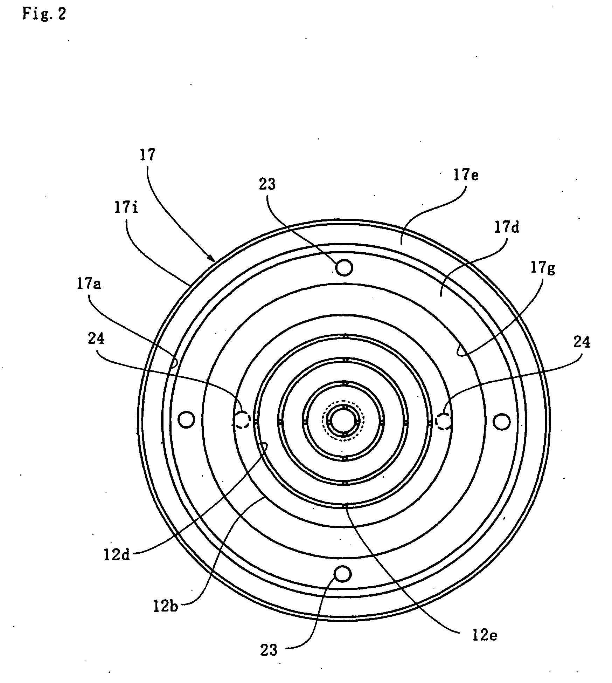

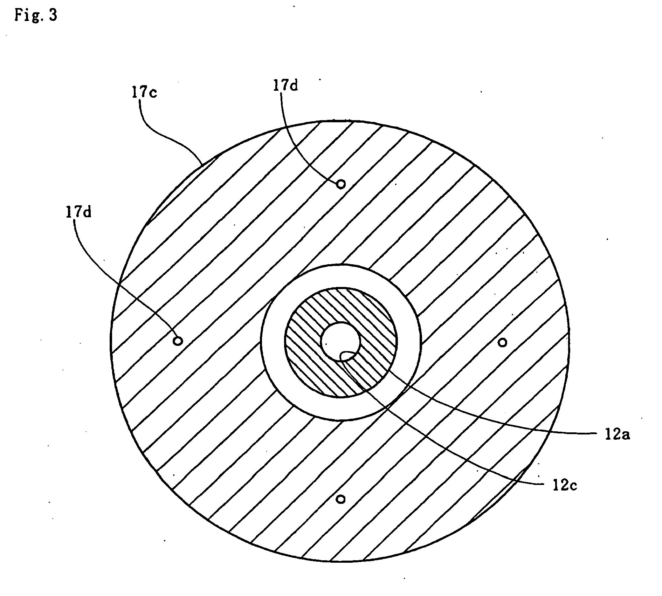

The chuck 12 includes: a shaft section 12a extending in the vertical direction; a wafer receiving section 12b having a large diameter that is provided at the upper face of the shaft section 12a so as to be integrated with the shaft section 12a; a transparent hole 12c (FIG. 3) that is provided at the center of the shaft section 12a and the wafer receiving section 12b to extend from the lower face of the shaft section 12a to the center of the wafer receiving section 12b in the vertical direction; a plurality of communication holes (not shown) each of which has one end communicates with the upper end of the transparent hole 12c, extends from the transparent hole 12c to the outer side in the radial direction of the wafer receiving section 12b to form in a radial pattern, and has the other end that is closed; a plurality of ring grooves 12d (FIG. 2) formed in a concentric manner at the upper face of the wafer receiving section 12b; a plurality of small holes 12e (FIG. 2) for allowing the communication hole to communicate with a ring groove 12d; and a vacuum pump (not shown) connected to the lower end of the transparent hole 12c (FIG. 1 and FIG. 2). The upper face of the wafer receiving section 12b has thereon the wafer receiving section 12b and the wafer 11 in a concentric manner. When the vacuum pump is driven to cause a negative pressure in the transparent hole 12c, the communication hole, the small hole 12e, and the ring groove 12d, the lower face 11c of the wafer 11 is sucked by the wafer receiving section 12b to retain the wafer 11 in the horizontal direction. The rotation means 13 has a driving motor (not shown) for rotating the shaft section 12a. By rotating the shaft section 12a by the driving motor, the wafer 11 retained by the wafer receiving section 12b is rotated together with the shaft section 12a and the wafer receiving section 12b.

The first nozzle 14 is provided at the upper part of the wafer 11 so as to be opposed to the upper face 11a of the wafer 11. The second nozzle 16 is provided at the upper part of the edge face 11b of the wafer 11 so as to be opposed to the edge face 11b of the wafer 11. The first nozzle 14 is connected to a main supply pump (not shown) via a main supply tube 21. The second nozzle 16 is connected to an auxiliary supply pump (not shown) via an auxiliary supply tube 22. The first nozzle 14 is structured so as to be movable by the first nozzle moving means (not shown) in the horizontal direction between a position opposed to the center of the upper face 11a of the wafer 11 and an evacuation position. The second nozzle 16 is structured so as to be movable by the second nozzle moving means (not shown) in the horizontal direction between a position opposed to the edge face lib of the wafer 11 and the evacuation position. When the wafer 11 is etched, the first nozzle 14 is moved by the first nozzle moving means between the center of the upper face 11a of the wafer 11 and the periphery edge of the wafer 11 and the second nozzle 16 is fixed by the second nozzle moving means at a position opposed to the edge face 11b of the wafer 11.

The single wafer etching apparatus 10 in this embodiment further includes a lower face blowing mechanism 17 through which the etching liquid 15 flowing along the edge face 11b of the wafer 11 provided on the chuck 12 is blown off by gas to the outer side in the radial direction of the wafer 11.

The lower face blowing mechanism 17 has: a ring-like jet orifice 17a opposed to the lower face in the vicinity of the edge face 11b of the wafer 11; a ring-like jet groove 17b in which an upper end communicates with the jet orifice 17a and which has a diameter smaller toward the lower part; and a gas supply means (not shown) that communicates with the jet groove 17b and that supplies compressed gas to the jet orifice 17a via the jet groove 17b (FIG. 1 and FIG. 2). The jet groove 17b is formed by attaching a cone member 17d and a taper member 17e to the upper face of a base member 17c in a concentric manner (FIG. 1). The base member 17c is formed to have a larger diameter than that of the wafer 11 and has the center at which a through hole 17f through which the shaft section 12a is loosely fitted. The center of the cone member 17d has a hole 17g having a large diameter and the outer periphery face of the cone member 17d is formed to have a cone-like shape having a smaller diameter toward the lower side. The taper member 17e is formed to have an outer diameter that is larger than the outer diameter of the wafer 11 and that is smaller than the outer diameter of the base member 17c. The taper member 17e is formed to have an inner periphery face having a diameter that is smaller toward the lower side. By mounting the taper member 17e on the base member 17c to subsequently mount the cone member 17d on the base member 17c, a ring-like clearance is formed between the inner periphery face of the taper member 17e and the outer periphery face of the cone member 17d. This ring-like clearance functions as the jet groove 17b. The jet groove 17b communicates with one end of four gas supply holes 17h formed in the base member 17c (FIG. 1 and FIG. 3). The other end of these gas supply holes 17h is connected to the gas supply means. The gas supply means is composed of a compressor for compressing gas (e.g., nitrogen gas, air) for example. Gas compressed by this gas supply means is supplied to the jet orifice 17a through a gas supply hole 17h and the jet groove 17b.

A fluid suction mechanism (not shown) is provided along the outer side having a predetermined interval to the outer periphery face of the wafer 11 retained by the chuck 12. Although not shown, this fluid suction mechanism has a liquid receiving tool for receiving the etching liquid 15 jumped from the wafer 11 and a fluid suction means for sucking the etching liquid 15 received by the liquid receiving tool.

It is noted that a fixed position NP of the second nozzle 16 is set in a range of -10 to 20 mm (preferably 1 to 5 mm) from the end of the outer periphery of a wafer to the inner side of the wafer in the radial direction. The etching liquid 15 is discharged through the second nozzle 16 with a flow rate NF of 0.1 to 3 liter/minute (preferably 0.2 to 1 liter/minute). The position BP of the jet orifice 17a is set in a range of 0 to 10mm (preferably 1 to 5 mm) from the end of the outer periphery of the wafer toward the inner side of the wafer in the radial direction. Gas is blown through the jet orifice 17a with a flow rate BF of 50 to 1000 liter/minute (preferably 100 to 500 liter/minute). When gas is blown through the jet orifice 17a with a flow rate of G liter/minute and the jet orifice 17a has a width of B mm, G/B is set to 50 to 1000 (preferably 100 to 500). The rotation speed of the wafer 11 is set to 200 to 800 rpm (preferably 300 to 500 rpm).

The reason why the fixed position NP of the second nozzle 16 is set in a range of -10 to 20 mm from the end of the outer periphery of the wafer toward the inner side in the radial direction of the wafer is that a range smaller than -10 mm causes a disadvantage in that chemical fluid from the second nozzle 16 does not reach a wafer and a range exceeding 20 mm has an influence on the in-plane flatness. The reason why the flow rate NF of the etching liquid 15 discharged through the second nozzle 16 is limited to the range of 0.1 to 3 liter/minute is that a range smaller than 0.1 liter/minute causes an insufficient effect by the chemical fluid from the second nozzle 16 and a range exceeding 3 liter/minute has an influence on the in-plane flatness. The reason why G/B is set to the range of 50 to 1000 is that the G/B lower than 50 causes a difficulty in gas supply and a range exceeding 1000 causes an insufficient gas supply flow velocity. The reason why the rotation speed of the wafer 11 is limited to a range of 200 to 800 rpm is that the rotation speed lower than 200 rpm causes a disadvantage in that the chemical fluid flows excessively and a range exceeding 800 rpm causes a difficulty in securing the wafer flatness after the processing.

The following section will describe an operation of the single wafer etching apparatus 10 having the structure as described above. First, the vacuum pump is activated to cause a negative pressure in the transparent hole 12c, the communication hole, the small hole 12e, and the ring groove 12d while the wafer 11 being placed on the chuck 12. This negative pressure retains the wafer 11 in a horizontal direction. While this condition is maintained, the driving motor of the rotation means 13 is activated to rotate the wafer 11 together with the shaft section 12a and the wafer receiving section 12b of the chuck 12 in a horizontal plane. Next, the gas supply means of the lower face blowing mechanism 17 is activated to blow compressed gas consisting of nitrogen gas or air from the jet orifice 17a through the gas supply hole 17h and the jet groove 17b, thereby forming a gas flow flowing to the outer side in the radial direction of the wafer 11. Then, the suction means of the fluid suction mechanism is activated to maintain the interior of the liquid receiving tool with a negative pressure. Next, the first nozzle moving means is activated to oppose the first nozzle 14 to the center of the wafer 11 and the second nozzle moving means is activated to oppose the second nozzle 16 to the edge face lib of the wafer 11. While this condition is maintained, the main supply pump is activated to supply the etching liquid 15 through the first nozzle 14 to the upper face 11a of the wafer 11 and the auxiliary supply pump is activated, thereby supplying the etching liquid 15 from the second nozzle 16 to the edge face 11b of the wafer 11.

The centrifugal force caused by the rotation of the wafer 11 in the horizontal plane gradually moves the etching liquid 15 supplied from the first nozzle 14 to the upper face 11a of the wafer 11 from the position at which the etching liquid 15 is supplied (e.g., a position in the vicinity of the center of the upper face 11a of the wafer 11) toward the edge face 11b of the wafer 11 while etching the work-affected layer of the upper face 11a of the wafer 11 to etch the edge face 11b when the etching liquid 15 reaches the edge face 11b of the wafer 11. Then, the etching liquid 15 is supplied from the second nozzle 16 to the edge face 11b of the wafer 11. Thus, a sufficient amount of the etching liquid 15 is supplied to the edge face 11b of the wafer 11. Then, the centrifugal force caused by the rotation of the wafer 11 changes the most part of the etching liquid 15 of the edge face 11b of the wafer 11 into liquid droplets that jump to the outer side of the wafer 11. The jumped etching liquid 15 enters the liquid receiving tool maintained to have a negative pressure and is discharged through a suction pipe by the negative pressure. On the other hand, a part of the etching liquid 15 flowing from the edge face 11b of the wafer 11 to the lower face 11c of the wafer 11 is blown off by the gas flow flowing in a gap GP between the upper face of the gas flow the chuck 12 and the lower face 11c of the wafer 11 to the outer side in the radial direction of the wafer 11 and is scattered to the outer side of the wafer 11. The scattered etching liquid 15 smoothly enters the liquid receiving tool maintained to have a negative pressure and is discharged by the negative pressure to the exterior of the chamber via the suction pipe.

Then, the etching liquid 15 supplied from the second nozzle 16 to the edge face 11b of the wafer 11 allows, even when the etching liquid 15 supplied to the upper face 11a of the wafer 11 via the first nozzle 14 is disordered at the upper face 11a, a sufficient amount of the etching liquid 15 to be supplied to the edge face 11b of the wafer 11, thus preventing the etching liquid 15 flowing to the edge face 11b of the wafer 11 from being disordered. Thus, even when the first nozzle 14 for supplying the etching liquid 15 to the upper face 11a of the wafer 11 is moved on the upper face 11a of the wafer 11, the etching liquid 15 can be uniformly flowed to the edge face 11b of the wafer 11 to stabilize the shape of the outermost periphery of the edge face 11b. As a result, the quality of the shape of the edge face 11b can be controlled with a relative ease.

### EXAMPLE

The following section will describe an example of the present invention together with a comparative example.

### <Example 1>

As shown in FIG. 1, the single wafer etching apparatus 10 was used to etch the silicon the wafer 11 to have a diameter of 300 mm and a thickness of 0.85 mm. Then, the gap between the upper face of the lower face blowing mechanism 17 and the lower face 11c of the wafer 11 was adjusted to 0.5 mm and the fixed position NP of the second nozzle 16 was set at a position 2 mm from the end of the outer periphery of the wafer toward the inner side in the radial direction of the wafer. The etching liquid 15 discharged through the second nozzle 16 was set to have the flow rate NF of 1 liter/minute and the position BP of the jet orifice 17a was set at a position 2 mm from the end of the outer periphery of the wafer toward the inner side in the radial direction of the wafer. The gas blown through the jet orifice 17a was set to the flow rate BF of 500 liter/minute and the gas blown through the jet orifice 17a was set to the flow rate of G liter/minute. When the jet orifice is assumed to have a width B mm, G/B was set to 500. The rotation speed of the wafer 11 was set to 600 rpm and the etching liquid 15 discharged through the first nozzle 14 was set to a flow rate of 5 liter/minute. The wafer 11 etched by this apparatus 10 was considered as the Example 1.

### <Comparative Example 1>

A wafer was etched in the same manner as in the Example 1 except for that a single wafer etching apparatus that did not have the second nozzle was used. This wafer was considered as the Comparative Example 1.

### <Comparative Test 1 and Evaluation>

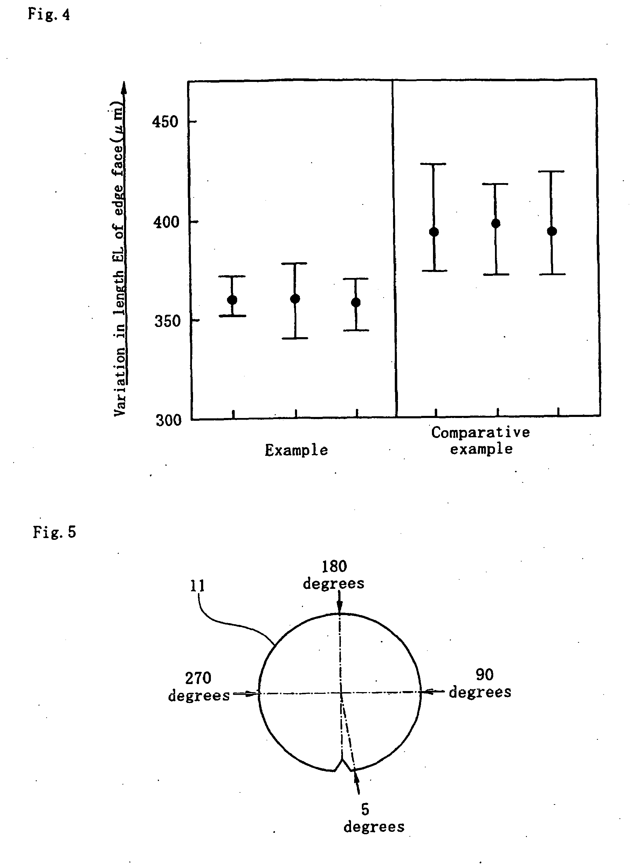

Three wafers of the Example 1 and three wafers of the Comparative Example 1 were measured with regards to the lengths EL (FIG. 1) of the respective edge faces in the horizontal direction to calculate the variation in the length EL of the respective wafers, the result of which is shown in FIG. 4. As is clear from FIG. 4, while the wafers of the Comparative Example 1 show the length EL of the edge faces in the horizontal direction of about 400 µm, the wafers of the Example 1 show the length EL of the edge faces in the horizontal direction of about 370 µm. While the wafers of the Comparative Example 1 show the variation in the lengths EL of the edge faces in the horizontal direction of 46 to 52 µm, the wafers of the Example 1 show the variation in the lengths EL of the edge faces in the horizontal direction of 20 to 37 µm.

### <Comparative Test 2 and Evaluation>

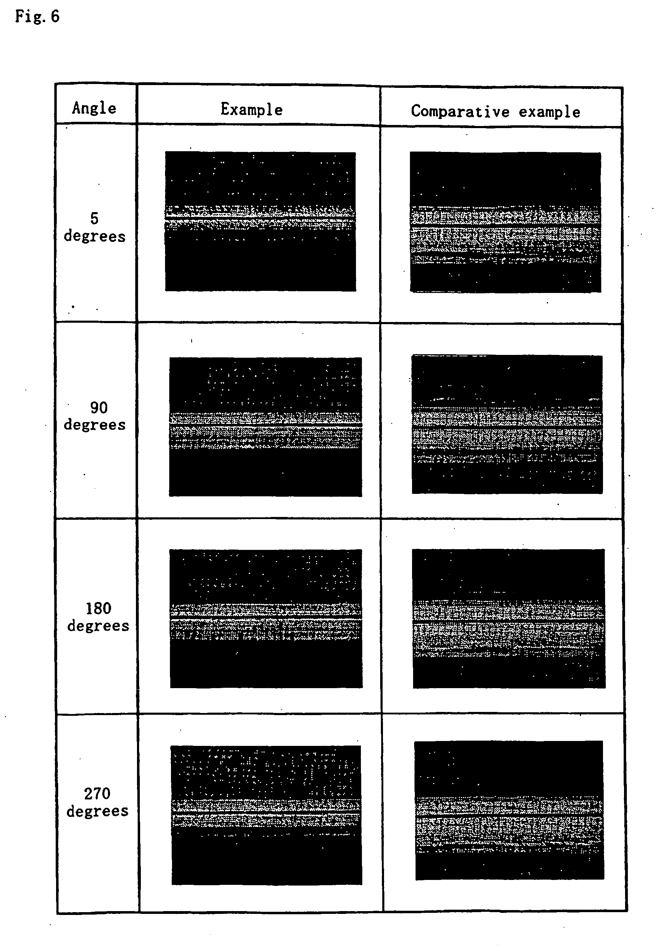

With regards to the wafers of the Example 1 and the Comparative Example 1, the in-plane variation of the edge shapes was observed. This in-plane variation was observed by photographing the outer periphery face of a single wafer in four directions (a direction having a 5 degrees, a direction having a 90 degrees, a direction having a 180 degrees, and a direction having a 270 degrees of FIG. 5), the result of which is shown in FIG. 6. As is clear from FIG. 6, while the wafers of the Comparative Example 1 show a significant in-plane variation in the shape of the edge face, the wafers of the Example 1 show a small in-plane variation of the shape of the edge face.

## Claims

1. A single wafer etching apparatus (10) for supplying etching liquid (15) to an upper face (11a) of a thin discoid wafer (11) obtained by slicing a semiconductor ingot while rotating the wafer (11) to etch the upper face (11a) and an edge face (11b) of the wafer (11), comprising:
a first nozzle (14) for supplying etching liquid (15) to the upper face (11a) and the edge face (11b) of the wafer (11),
a second nozzle (16) for supplying etching liquid (15) to the edge face (11b) of the wafer (11) that is opposed to the edge face, and
a lower face blowing mechanism (17) by which etching liquid (15) flowing along the edge face of the wafer (11) is blown off by gas jet toward an outer side in the radial direction of the wafer (11),
wherein the lower face blowing mechanism (17) has: a ring-like jet orifice (17a) opposed to the lower face of the wafer (11), a ring-like jet groove (17b) in which an upper end communicates with the jet orifice (17a) and which has a diameter smaller toward the lower part, and a gas supply means that communicates with the jet groove (17b) and that supplies compressed gas to the jet orifice (17a) via the jet groove (17b),
**characterized by** a first nozzle moving means moving the first nozzle (14) between the center of the upper face (11a) of the wafer (11) and the periphery edge of the wafer (11) during etching,
wherein the second nozzle (16) discharges the etching liquid with a flow rate of 0,1 to 3 liter/minute, preferably. 0,2 to 1 liter/minute,
wherein the ring-like jet orifice is provided in a range of 0 to 10 mm, preferably 1 to 5 mm from the end of the outer periphery of the wafer (11) toward the inner side of the wafer (11) in the radial direction.

2. The apparatus according to claim 1, wherein the second nozzle (16) is fixed at a predetermined position in a range of -10 mm to 20 mm, preferably 1 mm to 5 mm from an end of an outer periphery of the wafer (11) toward an inner side of the wafer (11) in a radial direction.

3. Method for etching an upper face (11a) and an edge face (11b) of a thin discoid single wafer (11) by supplying etching liquid to the upper face (11a) of said wafer (11) while rotating the wafer (11), the wafer being obtained by slicing a semiconductor ingot,
supplying etching liquid to the upper face (11a) of the wafer by a first nozzle,
supplying etching liquid to the edge face (11b) of the wafer by a second nozzle,
wherein the first nozzle (14) is moved between the center of the upper face (11a) and the periphery edge face of the wafer (11), and the second nozzle (16) is fixed at a position opposed to the edge face (11b) of the wafer (11),
wherein etching liquid (15) is discharged through the second nozzle (16) with a flow rate of 0,1 to 3 liter/minute, preferably 0,2 to 1 liter/minute,
wherein etching liquid flowing along the edge face (11b) of the wafer (11) is blown off by a gas jet directed to a lower side of the wafer (11) towards an outer side in the radial direction of the wafer (11).

4. The method according to claim 3, wherein the flow rate of the discharged etching liquid through the first nozzle (14) is higher than through the second nozzle (16).

## Patentansprüche

1. Einzelwaferätzvorrichtung (10) zum Zuführen einer Ätzflüssigkeit (15) zu einer oberen Fläche (11a) eines dünnen scheibenförmigen Wafers (11), welcher durch Schneiden eines Halbleiterrohlings gewonnen wird, während der Wafer (11) rotiert, um die obere Fläche (11a) und eine Randfläche (11b) des Wafers (11) zu ätzen, umfassend:
eine erste Düse (14) zum Zuführen der Ätzflüssigkeit (15) zu der oberen Fläche (11a) und der Randfläche (11b) des Wafers (11),
eine zweite Düse (16) zum Zuführen einer Ätzflüssigkeit (15) zu der Randfläche (11b) des Wafers (11), welche der Randfläche gegenüber liegt, und
einen Blasmechanismus (17) für eine untere Fläche, durch welchen Ätzflüssigkeit (15), welche entlang der Randfläche des Wafers (11) fließt, mit einem Gasstrahl in Richtung einer Außenseite in der radialen Richtung des Wafers (11) abgeblasen wird,
wobei der Blasmechanismus (17) für die untere Fläche aufweist: eine ringähnliche Strahlöffnung (17a) gegenüber der unteren Fläche des Wafers (11), eine ringähnliche Strahlnut (17b), in welcher ein oberes Ende in Verbindung mit der Strahlöffnung (17a) steht und welche einen in Richtung des unteren Teils kleineren Durchmesser aufweist, und ein Gaszuführungsmittel, welches mit der Strahlnut (17b) in Verbindung steht und welches komprimiertes Gas zu der Strahlöffnung (17a) über die Strahlnut (17b) zuführt,
**gekennzeichnet durch** ein Bewegungsmittel für die erste Düse, welches die erste Düse (14) zwischen der Mitte der oberen Fläche (11a) des Wafer (11) und dem Umfangsrand des Wafers (11) während des Ätzens bewegt,
wobei die zweite Düse (16) die Ätzflüssigkeit mit einer Strömungsgeschwindigkeit von 0,1 bis 3 1/min, vorzugsweise 0,2 bis 1 1/min, ausströmen lässt,
wobei die ringähnliche Strahlöffnung in einem Bereich von 0 bis 10mm, vorzugsweise 1 bis 5mm von dem Ende des Außenumfangs des Wafers (11) in Richtung der Innenseite des Wafers (11) in der radialen Richtung vorgesehen ist.

2. Vorrichtung nach Anspruch 1, wobei die zweite Düse (16) an einer vorbestimmten Position in einem Bereich von -10mm bis 20mm, vorzugsweise 1mm bis 5mm, von einem Ende eines Außenumfangs des Wafers (11) in Richtung einer Innenseite des Wafers (11) in einer radialen Richtung befestigt ist.

3. Verfahren zum Ätzen einer oberen Fläche (11a) und einer Randfläche (11b) eines dünnen scheibenförmigen einzelnen Wafers (11) durch Zuführen einer Ätzflüssigkeit zu der oberen Fläche (11a) des Wafers (11) während sich der Wafer (11) dreht, wobei der Wafer durch Schneiden eines Halbleiterrohlings gewonnen wird,
Zuführen einer Ätzflüssigkeit zu der oberen Fläche (11a) des Wafers mit einer ersten Düse,
Zuführen einer Ätzflüssigkeit zu der Randfläche (11b) des Wafers mit einer zweiten Düse,
wobei die erste Düse (14) zwischen der Mitte der oberen Fläche (11a) und der Umfangsrandfläche des Wafers (11) bewegt wird und die zweite Düse (16) an einer Position gegenüberliegend zu der Randfläche (11b) des Wafers (11) befestigt ist,
wobei eine Ätzflüssigkeit (15) durch die zweite Düse (16) mit einer Strömungsgeschwindigkeit von 0,1 bis 3 1/min, vorzugsweise 0,2 bis 1 1/min, ausgebracht wird,
wobei Ätzflüssigkeit, welche entlang der Randfläche (11b) des Wafers (11) fließt, durch einen Gasstrahl, welcher auf eine untere Seite des Wafers (11) gerichtet ist, in Richtung einer Außenseite in der radialen Richtung des Wafers (11) abgeblasen wird.

4. Verfahren nach Anspruch 3, wobei die Strömungsgeschwindigkeit der ausgebrachten Ätzflüssigkeit durch die erste Düse (14) größer als durch die zweite Düse (16) ist.

## Revendications

1. Appareil (10) de gravure d'une seule plaquette permettant de fournir du liquide de gravure (15) à une face supérieure (11a) d'une plaquette discoïde mince (11), obtenue par découpage en tranches d'un lingot semi-conducteur, tout en faisant tourner la plaquette (11), afin de graver la face supérieure (11a) et une face de bord (11b) de la plaquette (11), comprenant :
une première buse (14) destinée à fournir du liquide de gravure (15) à la face supérieure (11a) et à la face de bord (11b) de la plaquette (11),
une seconde buse (16) destinée à fournir du liquide de gravure (15) à la face de bord (11b) de la plaquette (11), qui fait face à la face de bord, et
un mécanisme de soufflage (17) de la face inférieure qui permet d'éliminer du liquide de gravure (15) s'écoulant le long de la face de bord de la plaquette (11) au moyen d'un jet de gaz dirigé vers un côté extérieur dans la direction radiale de la plaquette (11),
le mécanisme de soufflage (17) de la face inférieure comportant : un orifice de sortie de jet de type annulaire (17a) qui fait face à la face inférieure de la plaquette (11), une rainure de sortie de et de type annulaire (17b) dans laquelle une extrémité supérieure communique avec l'orifice de sortie de jet (17a) et dont le diamètre est plus petit en direction de la partie inférieure, et un moyen d'alimentation en gaz qui communique avec la rainure de sortie de jet (17b) et qui alimente en gaz comprimé l'orifice de sortie de jet (17a) via la rainure de sortie de jet (17b),
**caractérisé par** un moyen de déplacement de la première buse, déplaçant la première buse (14) entre le centre de la face supérieure (11a) de la plaquette (11) et le bord périphérique de la plaquette (11) pendant la gravure,
la seconde buse (16) fournissant le liquide de gravure selon un débit de 0,1 à 3 litres/minute, de préférence de 0,2 à 1 litre/minute,
l'orifice de sortie de jet de type annulaire étant prévu dans une plage de 0 à 10 mm, de préférence de 1 à 5 mm, à partir de l'extrémité de la périphérie extérieure de la plaquette (11) vers le côté intérieur de la plaquette (11) dans la direction radiale.

2. Appareil selon la revendication 1, dans lequel la seconde buse (16) est fixée dans une position prédéterminée dans une plage de - 10 mm à 20 mm, de préférence de 1 mm à 5 mm, à partir d'une extrémité d'une périphérie extérieure de la plaquette (11) vers un côté intérieur de la plaquette (11) dans une direction radiale.

3. Procédé pour graver une face supérieure (11a) et une face de bord (11b) d'une seule plaquette discoïde mince (11) en fournissant du liquide de gravure à la face supérieure (11a) de ladite plaquette (11) tout en faisant tourner la plaquette (11), la plaquette étant obtenue par découpage en tranches d'un lingot semi-conducteur,
en fournissant du liquide de gravure à la face supérieure (11a) de la plaquette (11) par une première buse,
en fournissant du liquide de gravure à la face de bord (11b) de la plaquette par une seconde buse,
la première buse (14) étant déplacée entre le centre de la face supérieure (11a) et la face de bord périphérique de la plaquette (11), et la seconde buse (16) étant fixée dans une position qui fait face à la face de bord (11b) de la plaquette (11),
le liquide de gravure (15) étant fourni à travers la seconde buse (16) selon un débit de 0,1 à 3 litres/minute, de préférence de 0,2 à 1 litre/minute,
du liquide de gravure qui s'écoule le long de la face de bord (11b) de la plaquette (11) étant éliminé par soufflage d'un jet de gaz dirigé sur un côté inférieur de la plaquette (11) vers un côté extérieur dans la direction radiale de la plaquette (11).

4. Procédé selon la revendication 3, dans lequel le débit du liquide de gravure fourni à travers la première buse (14) est supérieur à celui fourni à travers la deuxième buse (16).
